# EUROPEAN PATENT APPLICATION

(11) **EP 1 376 867 A1**
(43) Date of publication of application: **02.01.2004**
(21) Application number: 02360180.0
(22) Date of filing: 19.06.2002
(51) Int. Cl.: H03K 3/00, H03K 19/0175

(54) **Differential high speed cmos to ecl logic converter**

(71) Applicant: ALCATEL, 75008 Paris (FR)
(72) Inventor: Ilchmann, Frank, 13158 Berlin (DE)
(74) Representative: Brose, Gerhard, Dipl.-Ing.

(57) **Abstract**

A logic level converter for translating differential CMOS logic signals to into differential logic signal pairs such as those associated with ECL levels. The converter includes two components. A first component consists of two branches coupled to the switchable CMOS level input and it provides a first switchable translated output. The second component is an ECL current switch. The current associated with the converter is mirrored through the branches to minimize the effects of fabrication, temperature, and/or power supply vagaries, as well as a very fast and tolerance independent signal level translation.

## Description

### BACKGROUND OF THE INVENTION

### Field of the Invention

The present invention relates to circuitry for transmitting electrical signals from one location to another. In particular, the present invention relates to converters for changing the logic levels associated with the operation of Complementary Metal-Oxide-Silicon (CMOS) transistors to the logic levels associated with the operation of Emitter-Coupled Logic (ECL) transistors.

### Background

A voltage level converter is used to adjust the logic high and logic low voltage levels associated with a single input signal, or a pair of input signals, coming into the converter to high and low voltage levels compatible with downstream circuitry. The converter must transfer these electrical signals at desired amplitude and rate. The signal transfer occurs between active devices that are either on the same semiconductor-based chip or on different chips. The devices may be located proximate to one another, or they may be some distance from one another. One example of a proximate device interface requiring one or more bus connections is the coupling of one printed circuit board to another within a computing system, such as through a back plane bus. An example of a remote device interface requiring one or more bus connections is the coupling of one computing system to another. A continuing goal in all computing and communication systems is to be able to transfer electrical signals accurately and as fast as possible. In order to achieve that goal, it is important that those signals are transmitted at relatively uniform rates, amplitudes, and strengths. This is more likely to occur within a single computing system, less so when interfacing of a plurality of non-uniform computing systems is involved.

It is well known that in digital systems the signals moving between devices are categorized into logic level high (or "1" or "ON') and logic level low (or "0" or "OFF'). The particular signal potential that defines whether a logic high or a logic low is being transmitted is dependent upon the semiconductor components that form the circuitry associated with that transmission. The most common circuit configurations used to produce digital signals include, among others, Complementary Metal-Oxide-Silicon (CMOS), Transistor-Transistor Logic (TTL), and ECL―differential ECL in particular. Each of these logic configurations operates differently as a function of the "swing" between what constitutes a logic high signal and what constitutes a logic low signal.
For CMOS logic, which is based primarily on the use of slower, less-power-consuming Metal-Oxide-Silicon (MOS) transistors, a logic low signal is generally developed in the range of 0.6 volts (V) above a low-potential power rail GND, which may he at 0.0 V. A logic high signal is generally developed in the range of Vcc to Vcc-0.6 V, where Vcc may vary between *4.5* V and 5.5 V for a nominal 5-volt supply, or between 3.0 V and 3.6 V for a nominal 3.3-volt supply. For a 3.3-volt supply then, the differential swing between low and high must be at least 2.4 volts in order to ensure that a desired shift between a logic low and a logic high will occur.

TTL and ECL logic configurations, on the other hand, are based primarily on the use of faster, high-power-consuming bipolar transistors. The differential swing for a shift between a logic low and a logic high is significantly less than it is for CMOS operation, it may be as low as 0.4 volt. In ECL circuitry, a logic high is equivalent to a potential of about Vcc-0.8 V and a logic low is equivalent to a potential of about Vcc-1.9 V. Thus, in mating CMOS and non-CMOS transmissions, it can be seen that variations in potential swings will not automatically ensure the triggering of a desired swing from one logic level to another. Furthermore, minor potential swings in CMOS signals may not effect any logic level change therein; however, they may be significant enough to cause an unexpected change in an ECL logic value when transmitted to an ECL-based system.

Clearly, unexpected changes in logic values are not desirable. They can cause significant operational errors. Therefore, it is important to provide a logic level converter that will not generate excessive signal potential swings―other than those specifically desired to achieve a logic level shift. This problem is more likely to occur as transmission rates are increased. Increasing transmission rates enables the transfer of more data in a shorter time period and so is desirable in many respects. However, the gain in increased transmission rate is often undermined by an increase in signal noise. That is, a rapid change in signal level creates an oscillation about the steady state value corresponding to the sudden switching on or off of a transistor. The extent of the oscillation is dependent upon the particular transistor system used as well as the loading of the downstream-coupled circuit.

As transistors become increasingly smaller in order to achieve the faster transmission rates of interest, the corresponding differential swings associated with their logic outputs are reduced. When the wider-swing CMOS logic systems interface with smaller-swing bipolar-transistor-based logic systems the noise associated with CMOS operation may generate enough of a swing to cause an undesired transistor switching. The signal bounce that occurs with the rapid switching often creates reflections in transmission media. It is therefore important to minimize distortions associated with signal switches. However, efforts to minimize distortions can result in increased signal propagation delays―an undesirable condition in smaller, faster systems. It is also to be noted that with increasingly smaller devices, the effects of fabrication vagaries on signal distortion are magnified. Therefore, to the extent such vagaries can be neutralized, the logic level conversion can be achieved without sacrificing transmission rates.

CMOS-to-ECL converters are well known. Examples of prior converters include the circuits disclosed in U.S. Pat. No. 5,343,093, U.S. Pat. No. 5,311,082 issued to Tran, and U.S. Pat. No. 5,117,134 issued to Aso, as well as U.S. Pat. No. 6,175,249 issued to Goodell. Each of the noted prior devices provides for shifting of the logic levels associated with both of the complementary signals associated with the converter.

To that end, they subject both signals to undesirable distortions that can occur during signal transitions. In addition, the Tran converter is referenced to the high-potential power rail and more susceptible to temperature, fabrication, and Vcc changes affecting signal amplitude and transmission rate. The Aso circuit requires an extra switching branch in order to adjust for common-mode effects associated with the MOS-level potentials. An added and undesirable prospect when smaller devices are of importance.

Therefore, what is needed is a logic level converter that can translate MOS-level signals into ECL-level signals with minimum propagation delay and little distortion. The Goodell circuit is asymmetric and has no differential output. What is also needed is a logic level converter that is relatively independent of temperature, fabrication, and Vcc vagaries. Further, what is needed is a logic level converter that is relatively simple to fabricate and that does not take up excess chip space.

### BRIEF DESCRIPTION OF THE INVENTION

It is an object of the present invention to provide a logic level converter that can translate differential MOS-level signals into differential ECL-level signals with minimum propagation delay and little distortion. It is also an object of the present invention to provide such a logic level converter that is relatively independent of temperature, fabrication, and Vcc vagaries.

Another object of the present invention is to provide a logic level converter that is symmetric, relatively simple to fabricate and that does not take up excess chip space.

These and other objectives are achieved in the present invention by differential triggering an ECL current switch resulting in a fast and tolerance independent level conversion.

An ECL current switch is triggered by two pairs of P-type semiconductor (P-channel) field-effect transistors (PFETs), that will only switch the base current of the ECL transistors. The four PFETs are symmetrically differentially arranged into two branches. Each of the branches consist of two PFETs in series forming a potential divider and trigger one base of a transistor of the ECL current switch. Hence the PFETs can be small dimensioned and the time for switching can be reduced.

The changeover between the ECL transistors via the PFETs switch is defined by the level resulting from the voltage on resistor R1, i.e. the base potential of the two PFET branches. In order to ensure that the swinging output switches between appropriate potentials pursuant to the signal level at the converter's input, the current for R1 and the ECL current switch comes from current source and is definable by a reference voltage Vref.

The converter of the present invention is preferably designed such that the current through the first branch mirrors the current through the second branch. In that way, current variations caused by temperature, fabrication, and/or Vcc changes are matched in both branches. Thus, while a current change in the branch coupled to the referenced output may cause a variation in the potential of that output, the same sort of current change will cause a similar modification in the changing potential of the switching output. The potential differential will therefore remain the same in a suitable ECL range. Of course, this technique may be applied to other converters having alternative required potential swings.

The CMOS to ECL signal conversion is achieved by a differential logic level converter having a pair of input nodes, for receiving a pair of input signal to be converted, and a pair of output nodes, said logic level converter comprising:
- a first converter component, comprising two identical branches with field-effect transistors, implementing a complementary differential potential switch, having an input coupled crosswise to the gates of the differential switching field-effect transistors,
- a second converter component, comprising an Emitter-Coupled Logic current switch, consisting of two identical branches, where the bases of the two transistors are connected with the first converter component's branch outputs, respectively, and where the collectors are the output nodes, and
- wherein a constant voltage level is associated with the first component and a constant current source is associated with the second component.

The output of said first converter component switches with changes in the potential of the input nodes, and the output of said second converter component switches with changes in the output potentials of the said first converter component the potential of the output nodes.

The first converter component includes two identical branches that might consist of two FETs in series, where each branch is connected to Vcc or GND and a definable base potential, and where the inputs are connected anti-symmetrical with the gates and the outputs are the intermediate drain potentials. The FETs might be realized by PMOS transistors.

The constant voltage level might be implemented by current source connected creating a constant voltage on a resistor, e.g. a transistor coupled via two resistors to a power supply and where the basis is connected with a reference potential and the collector has the constant voltage potential.
The current source might be implemented by a transistor coupled via a resistors to GND and where the basis is connected with a reference potential and the collector provides the constant current for the emitters of the ECL current switch.

The second converter component might include two identical branches, each consisting of a transistor and a resistor in series, and where the emitters of the transistors are connected and the resistors are connected with Vcc, and where the bases are the inputs and the collectors are the output nodes. The transistors might be NPN transistors.

The CMOS to ECL signal conversion is achieved by a process for converting a pair of complementary input signals into a pair of complementary output signals comprising the steps of:
- directing the CMOS-input signal to a first converter component having two first output potentials that switches with changes in the potential of the input signal, and
- using the two first output potentials in a second component generating an ECL-output potential,
where, optionally a step of regulating the potential of said first output potential and a step of regulating the potential of said ECL-output signal is added.

A central application for these circuits might be a transmission (network) equipment for communication networks, e.g., a add drop multiplexer, a repeater, or a cross-connect comprising a differential logic level converter as described.

### OBJECTS AND ADVANTAGES OF THE INVENTION

The symmetric designs of the two potential dividing branches as well as the ECL current switch results in minimum propagation delay, very low skew for low-to-high and high-to-low transitions, and minimum pulse width distortion. The branches share any potential deviations that could be caused by fabrication, temperature, and/or Vcc variations equally such that the desired potential differential will remain substantially constant.

Accordingly, it is an object and advantage of the present invention to have a very small retention period (less than 100ps), an CMOS compliant input interfacing, an ECL compliant output interfacing, only few components (transistors), temperature, operating voltage, and technology parameter variation independent level conversion.

Another advantage of the present invention is the possible low operating voltage, e.g. 2.5V.

These and other advantages of the present invention will become apparent upon review of the following detailed description, the accompanying drawings, and the appended claims.

### BRIEF DESCRIPTION OF THE FIGURES

**Figure. 1** is a simplified schematic diagram of the preferred design of the logic level converter of the present invention.
**Figure. 2** is a waveform illustrating the switching characteristics of the logic level converter of the present invention shown in FIG. 1.

### DETAILED DESCRIPTION OF THE INVENTION

Those of ordinary skill in the art will realize that the following description of the present invention is illustrative only and is not intended to be in any way limiting. Other embodiments of the invention will readily suggest themselves to such skilled persons from an examination of the within disclosure.

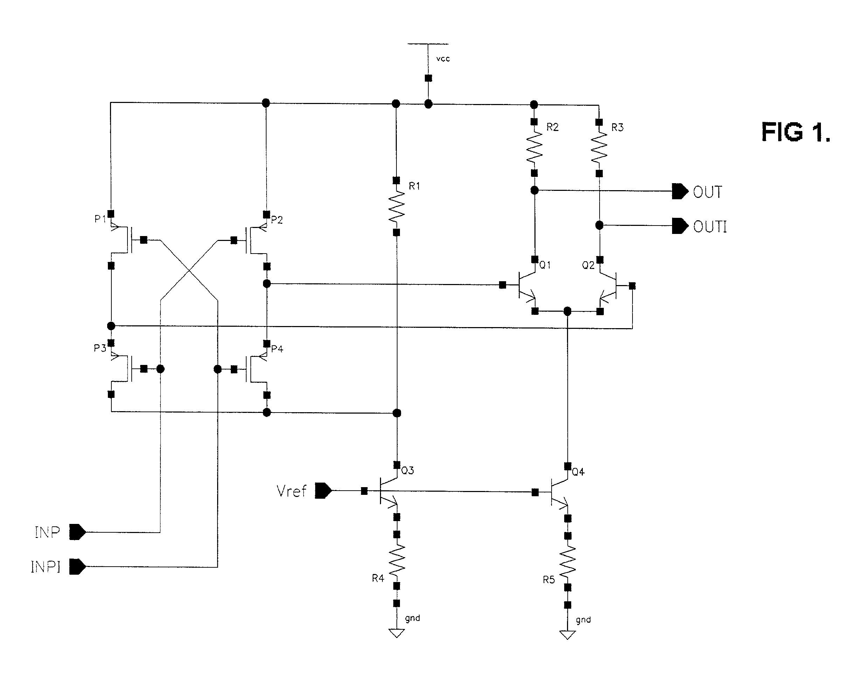

A high speed, low skew, logic level converter of the present invention is shown in simplified form in FIG. 1. The converter is designed to translate a differential complementary pair of input signals at input node INP and INPI (input and inverted input) from a potential associated with CMOS logic levels into a differential complementary pair of output signals at output node OUT and OUTI that are at potentials associated with ECL logic levels. It is contemplated that the potentials associated with OUT and OUTI may be developed by the converter at levels other than those related to ECL including, but not limited to Gunning Transceiver Logic (GTL).

The converter of the present invention includes two switching components, a first potential switch and a second current switch.

The first potential switch formed by the PFETs P1, P2, P3, and P4. The PFETs are arranged into two branches, a first branch consisting of PFET P1 in series with PFET P3, where the source of PFET P1 is connected with Vcc, and the drain of PFET P3 is connected with a base potential. The gate of PFET P1 is connected with the input INPI and the gate of PFET P3 is connected with the input INP. Symmetrically, a second branch consisting of PFET P2 in series with PFET P4, where the source of PFET P2 is connected with Vcc, and the drain of FET P3 is connected with the base potential. The gate of PFET P2 is connected with the input INP and the gate of PFET P4 is connected with the input INPI.

The base potential of the two branches is defined by the constant current through resistor R1. Resistor R1 is connected with Vcc and the collector of transistor Q3, the emitter of transistor Q3 is connected via the resistor R4 with GND, hence forming a constant current source. A reference voltage on the basis of transistor Q3 allows to adjust the base potential.

The ECL current switch consists of two transistors Q1 and Q2, where the coupled emitters are connected with a current source. Each of the collectors is connected via a resistor with Vcc, Q1 with R2 and Q2 with R3. The collector of transistor Q1 is the output OUT, and symmetrically, the collector of Q2 is the output OUTI.

The current source connected with the two emitters of the transistors Q1 and Q2 is similar to the current source for the resistor R1. It consists of a transistor Q4, where the emitter is connected via a resistor R5 with GND. The collector of transistor Q4 is connected with the two emitters of transistor Q1 and Q2. A reference voltage on the basis of transistor Q4 allows to adjust the current.

The outputs potentials of the first switching component, the potential switch are connected with the input of the ECL current switch. The drain of PFET P1 is connected with the basis of transistor Q2, and the drain of PFET P2 is connected with the basis of transistor Q1.

Assume node INP has low-potential and consequently INPI has high potential. Then both PFETs P2 and P3 are conducting and the other PFETs P1 and P4 are closed. The base of transistor Q1 is now connected with Vcc and the base of transistor Q2 has now the base potential of the potential switch. This has the effect that Q1 is open and Q2 is closed. The OUT potential is low, defined by the voltage on resistor R2. Since transistor Q2 is closed, OUTI is connected via R3 with Vcc and is high.

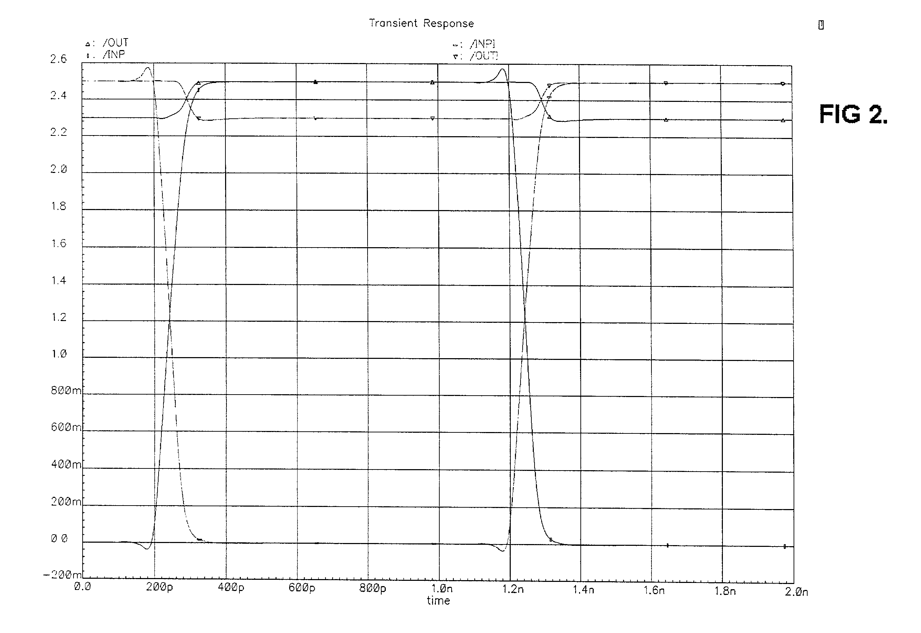

When INP changes to high potential and consequently INPI has low potential, the PFETs P2 and P3 are closed, and PFETs P1 and P4 are conducting. PFET P1 connects the base of transistor Q2 with Vcc and PFET P4 connects the base of transistor Q1 with the potential defined by R1. The change process is very fast since the PFETs only have to switch the base currents of transistor Q1 and Q2. Due to the change of the potentials on the bases of the transistors Q1 and Q2, the ECL current switch changes the output potentials. The output load (succeeding ECL circuit) is shifted by the two bipolar transistors. This has the effect that the signal is changing very fast. This is illustrated by the diagram of Figure 2.

Figure 2. provides an illustration of the advantage in using the converter of Figure 2. Specifically, of the waveforms shown,
- the line labeled with 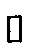 is the CMOS-level signal supplied at input INP and
- the line labeled with 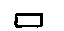 is the CMOS-level signal supplied at input INPI for a 3.3-Volt supplied system.
- The line labeled with Δ shows the potential associated with output OUT and
- the line labeled with ∇ shows the potential associated with output OUTI.

It can be seen that a change of a differential CMOS-input potentials force a change of the differential ECL-output signal within 100psec.
A logic low at the input results in a logic low at the output and a logic high at the input results in a logic high at the output.
Thus, for the noted example of the present invention, a full-swinging CMOS input can be translated into a differential pair of output signals having a differential of about 0.2 V. In summary, the converter accomplishes CMOS-to differential-ECL translation of node INP and node INPI by changing the potential of node OUT and node OUTI.

### Alternative Embodiments

Although illustrative presently preferred embodiments and applications of this invention are shown and described herein, many variations and modifications are possible which remain within the concept, scope, and spirit of the invention, and these variations would become clear to those of skill in the art after perusal of this application. For example, the current source for the ECL current switch as well as the base potential could be implemented using multiple reference voltages or multiple transistors. Obviously the dual circuit (N-type semiconductor (N-channel) FETs with PNP transistors) works similarly, etc.

The invention, therefore, is not intended to be limited except in the spirit of the appended claims.

## Claims

**1.** A **differential logic level converter** having a pair of input nodes, for receiving an differential input signal to be converted, and a pair of output nodes, serving a differential output signal, said logic level converter comprising:
- a first converter component, comprising two identical branches with two field-effect transistors, implementing a potential switch, having an input coupled crosswise to the gates of the field-effect transistors,
- a second converter component, comprising an Emitter-Coupled Logic current switch, consisting of two identical branches, where the bases of the two transistors are connected with the first converter component's branch outputs, and where the collectors are the output nodes,
- wherein a constant voltage level is associated with the first component and a constant current source is associated with the second component.

**2.** The **converter** as claimed in claim 1, wherein said first converter component includes:
- two identical branches consisting of two field-effect transistors in series,
- where each branch is connected to Vcc or GND and a definable base potential, and
- where the inputs are connected crosswise with the gates, and the outputs are the intermediate drains.

**3.** The **converter** as claimed in claim 2, wherein said the field-effect transistors are P-type semiconductor (P-channel) metal-oxide-semiconductor field-effect transistors.

**4.** The **converter** as claimed in claim 1, wherein said constant voltage level is adaptable and implemented by a resistor and current source.

**6.** The **converter** as claimed in claim 1, wherein said current source is adaptable and implemented by a transistor coupled via a resistors to GND and where the basis is connected with a reference potential providing the constant current for the emitters of the ECL current switch.

**7.** The converter as claimed in claim 1, wherein said second converter component includes
- two identical branches, each consisting of a transistor and a resistor in series, and
- where the emitters of the transistors are connected and the resistors are connected with Vcc, and
- where the bases are the inputs and the collectors are the output nodes.

**9.** The converter as claimed in claim 7 wherein said the transistors are NPN transistors.

**10.** A transmission (network) equipment for communication networks comprising a differential logic level converter having a pair of input nodes, for receiving an input signal to be converted, and a pair of output nodes, said logic level converter comprising:
- a first converter component, comprising two identical branches with field-effect transistors, implementing a potential switch, having an input coupled crosswise to the gates of the field-effect transistors,
- a second converter component, comprising an Emitter-Coupled Logic current switch, consisting of two identical branches, where the bases of the two transistors are connected with the first converter component's branch outputs, and where the collectors are the output nodes,
- wherein a constant voltage level is associated with the first component and a constant current source is associated with the second component.
